# EUROPEAN PATENT APPLICATION

(11) **EP 4 390 992 A1**
(43) Date of publication of application: **26.06.2024**
(21) Application number: 22215263.9
(22) Date of filing: 21.12.2022
(51) Int. Cl.: H01G 4/224, H01G 9/08, H05K 3/30, H01G 2/04, H01G 2/06, H01G 2/10, H01G 4/40, H05K 1/00, H01G 11/82, B60R 16/03, H05K 5/00, H05K 7/12, H05K 7/14, H01G 9/28, H01G 11/08

(54) **A MOUNTING STRUCTURE FOR A CAPACITOR AND A METHOD FOR MOUNTING A MOUNTING STRUCTURE TO A HOUSING**

(71) Applicant: Veoneer Sweden Safety Systems AB, 10302 Stockholm (SE)
(72) Inventor: LETUVE, Jeremy, 95800 Cergy-Pontoise (FR)
(74) Representative: Reichert & Lindner Partnerschaft Patentanwälte

(57) **Abstract**

The invention relates to a mounting structure (3) for a capacitor (4) and a method for mounting a mounting structure (3) to a housing (2) of an electronic control unit (1). The mounting structure (3) has a plurality of reinforcement ribs (33) formed in an upper surface of a base (30) of the mounting structure (3). Additionally, the mounting structure (3) has a centering feature (25) and an opening (26) formed in the base (30) of the mounting structure (3). For fastening, locating pins (24) engage the opening (26) and the centering feature (25).

## Description

### FIELD OF THE INVENTION

The invention relates to a mounting structure for a capacitor. The mounting structure is configured by a base, at least one pair of holding elements, two towers each for receiving of an insulation displacement connector, an alignment support and support surfaces.

Additionally, the invention relates to a method for mounting a mounting structure to a housing of an electronic control unit.

### DESCRIPTION OF THE BACKGROUND ART

CN 207818380 U discloses an electrolytic capacitor mount.

CN 210575548 U discloses a capacitor installation structure comprising a fixed frame which is an insulator. The fixed frame is fixed on a circuit board. The fixing frame is rectangular, and the shape of the fixing frame is matched with the shape of the capacitor. The capacitor is clamped in the fixed frame. Clamping devices for fixing the capacitor are symmetrically arranged on the inner wall of the fixing frame. The clamping devices are insulators, and each clamping device comprises an elastic component.

An advanced driver-assistance system (ADAS) is any of a group of electronic technologies that assist drivers in driving and parking functions. Through a safe human-machine interface, ADAS increases car and road safety. ADAS uses automated technology, such as sensors and cameras, to detect nearby obstacles or driver errors, and respond accordingly.

As known, an electrical control unit (ECU) is an embedded electronic device with ADAS and/or Rich Communication Services (RCS) functions. A power supply and/or an energy reserve must be ensured during the product lifetime and even in case of accidents.

A typical ECU consists of a printed circuit board (PCB), a housing, a cover and, in some cases, a backup power unit. It must be ensured that the ECU is supplied with power even in cases where the main power unit has a malfunction. For this reason, the backup power unit is provided, which is often a relatively heavy capacitor. In the housing, the fixation of the backup power unit is realized by means of a mounting structure, also called "cradle", with a plastic snap-fit solution. The mounting structure is mounted and fixed in the housing.

### SUMMARY OF THE INVENTION

It is an object of the invention to provide a mounting structure for a capacitor which can be securely fastened to a housing part so that the mounting structure withstands mechanical and/or climatic constraints.

The above object is achieved by a mounting structure according to claim 1.

It is a further object of the invention to provide a method for mounting a mounting structure to a housing of an electronic control unit such that the mounted mounting structure withstands mechanical and/or climatic constraints and the electric connection between the printed circuit board and the capacitor does not come loose.

The above object is achieved by a method for mounting a mounting structure to a housing of an electronic control unit according to claim 7.

In an embodiment, the mounting structure for a capacitor comprises a base, at least one pair of holding elements and two towers each for receiving an insulation displacement connector. Additionally, an alignment support and support surfaces for the capacitor are provided as well. The mounting structure has a plurality of reinforcement ribs formed in an upper surface of the base of the mounting structure. In addition, a centering feature and an opening are formed in the base of the mounting structure.

The advantage of the mounting structure is that it is mechanically stable and can be reproducibly positioned in a housing.

According to a further embodiment, the mounting structure is defined by a two pairs of holding elements. The advantage of this embodiment is that a more uniform distribution of the holding force for the capacitor is provided.

In a further embodiment of the mounting structure, the mounting structure is injection moulded and the holding elements, the two towers, the alignment support, the support surfaces and the reinforcement ribs are integral parts of the injection moulded mounting structure. The advantage is that the molding process allows that the elements of the mounting structure are all integral parts of the mounting structure.

According to a further embodiment, the mounting structure has a plurality of grooves formed in a bottom surface of the base of the mounting structure. The advantage of this embodiment is that the grooves allow a flow of a chemical substance that can be applied to the surface of the cover or any other housing part.

The applied chemical substance has fixing properties of the mounting structure to the inner surface of the cover of the housing. The chemical substance cab be for example in the form of an adhesive or a sealant.

In an embodiment of the mounting structure, the holding elements are configured to hold the capacitor, and the towers of the mounting structure receive leads of the capacitor.

In an embodiment of the method for mounting a mounting structure to a housing of an electronic control unit, several steps are provided. Initially, a glue is applied in a center of an area between locating pins provided on an inner surface of a cover of the housing. Next, at least one opening and at least one centering feature of a base of the mounting structure is aligned with respective locating pins on the inner surface of the cover of the housing. Then, the mounting structure is pressed against the inner surface of the cover so that the locating pins engage the at least one opening and the at least one centering feature respectively. By pressing the mounting structure against the inner surface of the cover of the housing, the glue is squeezed between the inner surface of the cover and a bottom surface of the base of the mounting structure.

The advantage of this method is that the mounting structure can be securely fixed to the inner surface of a cover of a housing so that it can withstand mechanical and/or climatic constraints and neither the mounting structure nor the capacitor will come loose. The mounting structure (cradle) with the capacitor, which together have a considerable weight, are subjected to vibrations and cyclic mechanical stress during the product lifetime. The inventive mounting concept of the has the advantage is that the weight (mounting structure and capacitor) is no more on the printed circuit board, which is now free of this extra weight, so the mechanical constraints on the printed circuit board are significantly lowered. This concept improves reliability and performance of the ECU.

Mounting of the mounting structure together with the capacitor to the inner surface of the housing cover also eliminates the need to mount the mounting structure on the PCB. This way of mounting provides more space for components on the PCB and an easier routing. It also eliminates mechanical stress on the PCB and improves the sensor transfer function (for the RCS).

According to a further embodiment of the method, a plurality of grooves are formed in the bottom surface of the base of the mounting structure. The advantage of this embodiment is that the chemical substance is squeezed into the grooves and distributed when the mounting structure is pressed against the inner surface of the cover. The grooves provide a structured and uniform distribution of the chemical substance between the bottom surface of the base of the mounting structure and the cover of the housing.

According to a further embodiment, a shoring is applied to the capacitor and the mounting structure. For example the shoring of the capacitor to the mounting structure can be done by an adhesive tape. The adhesive tape or any other type of shoring ensures that the capacitor will remain in the mounting structure in the event of a drop test, a severe crash of the vehicle.

A violent shock can be simulated by drop tests, which are quick ways to simulate a violent shock. Nevertheless, the mounting structure must withstand all typical environmental constraints of vehicles. In real life, the product must withstand mechanical constraints (i.e. vibrations, violent shocks etc.) and climatic constraints (i.e. temperature, temperature change rate, humidity etc.)

Initial drop tests, as an easily available test regime, have shown that the fixing technology with a chemical substance withstands mechanical stresses in a drop tests. The next test campaign has proved that the fixing properties of the chemical substance still performs after harsh aging and environmental tests (vibration, shock, humidity, temperature).

Nowadays, products (ECUs, ADAS or RCS) have an aluminium die cast housing, in which the capacitor for the energy reserve is mounted in a standalone mounting structure (cradle) on the PCB. The disadvantage of installing the mounting structure on the PCB results in mechanical stresses on the PCB. During the product lifetime, the mounting structure with the capacitor has a significant weight, which in combination with vibrations leads to cyclic stress on the PCB and to perturbations on sensors for transmission functions (for ECU, ADAS or RCS).

The mounting structure according to the invention may also be part of an electronic control unit (ECU) of a vehicle to hold a capacitor in position and to ensure a power supply to the ECU even after a failure of the central power supply. The mounting structure according to the invention enables a simple, cost effective and permanent fixation of the capacitor in the ECU.

### BRIEF DESCRIPTION OF THE DRAWINGS

The numerous advantages of the disclosure may be better understood by those skilled in the art by reference to the accompanying figures in which:
Figure 1 shows a schematic view of the placement of an electronic control unit (ECU) in a vehicle.
Figure 2 is a perspective view of an embodiment of a prior art mounting structure for at least one capacitor (energy reserve) to a housing part.
Figure 3 is a perspective view of another embodiment of a prior art mounting structure for a capacitor (energy reserve) to the bottom of a housing part.
Figure 4 is a perspective view of an embodiment of the mounted mounting structure (with capacitor) according to the invention.
Figure 5 is another perspective view of the mounted mounting structure as shown in Fig. 4.
Figure 6 is a perspective view of the mounting structure as shown in Fig. 4, without the capacitor inside.
Figure 7 is another perspective view as shown in Fig. 6 of the mounting structure as shown in Fig. 4.
Figure 8 is a perspective view of an embodiment of the bottom of the mounting structure as shown in Fig. 4.
Figure 9 is a schematic view of an initial method step for mounting the mounting structure.
Figure 10 is a schematic view of a subsequent method step for mounting the mounting structure.
Figure 11 is a schematic view of a method step for mounting the capacitor into the mounted mounting structure.
Figure 12 is a schematic view of the capacitor mounted and secured in the mounting structure.

### DETAILED DESCRIPTION

In the ensuing description, numerous specific details are provided to enable maximum understanding of the embodiments that are provided by way of example. The embodiments may be implemented with or without specific details, or else with other methods, components, materials, etc. In other circumstances, well-known structures, materials, or operations are not illustrated or described in detail so that various aspects of the embodiments will not be obscured. Reference in the course of the present description to "an embodiment" or "one embodiment" means that a particular structure, peculiarity, or characteristic described in connection with its implementation is comprised in at least one embodiment. Hence, phrases such as "in an embodiment" or "in one embodiment" that may recur in various points of the present description do not necessarily refer to one and the same embodiment. Furthermore, the particular structures, peculiarities, or characteristics may be combined in any convenient way in one or more embodiments.

Same reference numerals refer to same elements or elements of similar function throughout the various figures. Furthermore, only reference numerals necessary for the description of the respective figure are shown in the figures. The embodiments shown only represent examples of how the invention can be carried out. This should not be considered as a limitation of the invention.

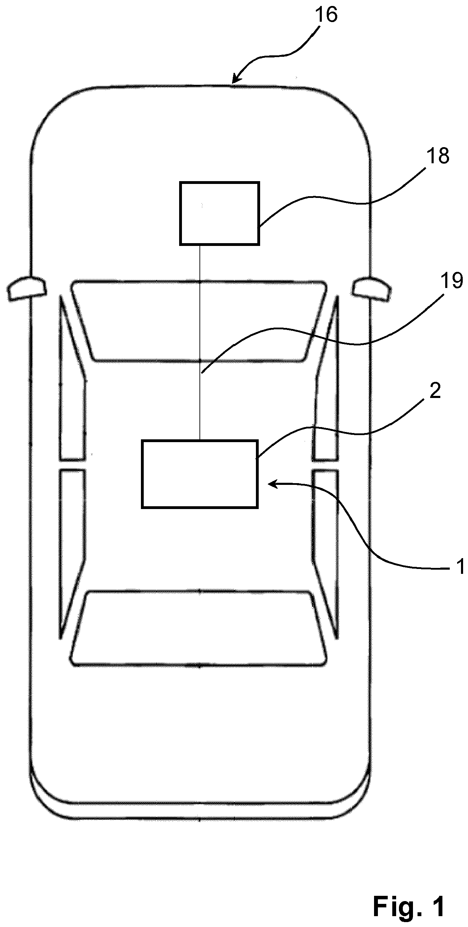

**Figure 1** shows a schematic view of an embodiment of a placement of an electronic control unit (ECU) **1** for a vehicle **16.** Electronic control unit **1** controls one or more electrical systems of vehicle **16** and is enclosed by a housing **2.** Housing **2** may be made of plastics or metallic materials. In cases where vibrations are more extreme during use of vehicle **16,** housing **2** may be made of metallic materials, such as die-cast aluminium. To supply electrical power to ECU **1,** ECU **1** is electrically connected to a vehicle battery **18** (main battery), typically by an electric line **19.**

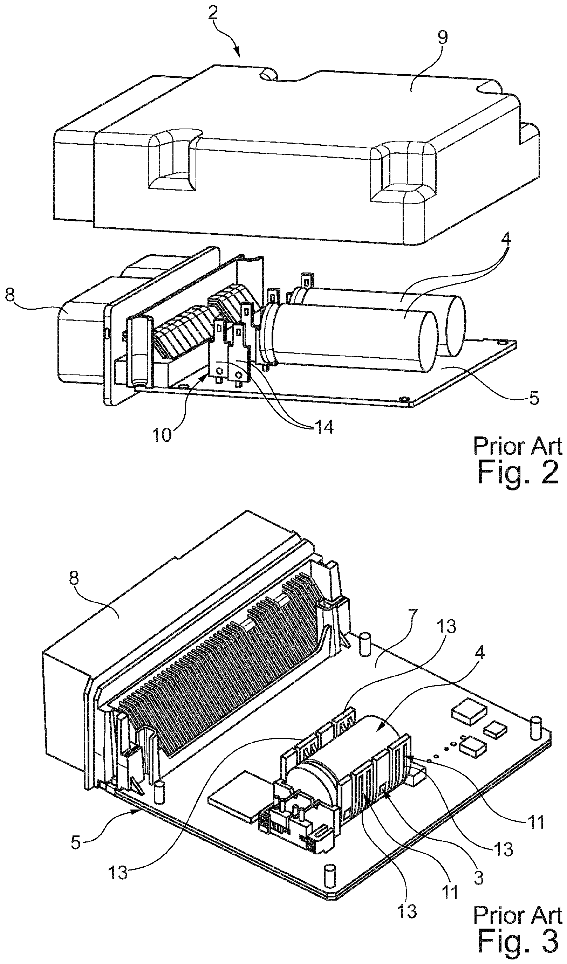

**Figure 2** shows a perspective view of an embodiment of a prior art mounting structure for a housing **2** which encloses at least one capacitor **4** as an energie reserve. The exploded perspective view of the housing **2** for an electric circuitry **10** shows the at least one capacitor **4.** The electric circuitry **10** requires some energy reserve capabilities. According to the prior art embodiment shown here, the electric circuitry **10,** together with the housing **2,** is an engine control unit (ECU) for a vehicle (see Figure 1). However, the invention is not limited to an ECU. The housing **2** is closed by a cover **9.** The bottom **5,** the housing cover **9** and an electric connector **8** enclose the electric circuitry **10** and at least one capacitor **4.** A plurality of contact pins **14** are attached to the electric circuitry **10** to provide electric contact between the at least one capacitor **4** and the electric circuitry **10.**

**Figure 3** shows a perspective view of an embodiment of a prior art mounting structure **3** (cradle) for a capacitor **4.** In the embodiment shown here, the mounting structure **3** is mounted on a circuit board **7,** which in turn rests on the bottom **5** of the housing **2** (see Figure 2). The mounting structure **3,** mounted on the printed circuit board **7,** holds the capacitor **4.** The heavy capacitor **4** mounted on the printed circuit board **7** leads to mechanical stresses on the printed circuit board **7.**

Here two pairs **11** of holding elements **13** extend upward from the mounting structure **3.** The holding elements **13** are elastic and keep the capacitor **4** in position. The type of mounting structure **3** shown here is simply based on the interaction between the holding elements **13** (e.g., plastic snaps) and the capacitor **4,** which means that the holding elements **13,** which are subjected to an elastic force by the insertion of capacitor **4** into the mounting structure **3,** provide a necessary retention force to keep the capacitor **4** in position.

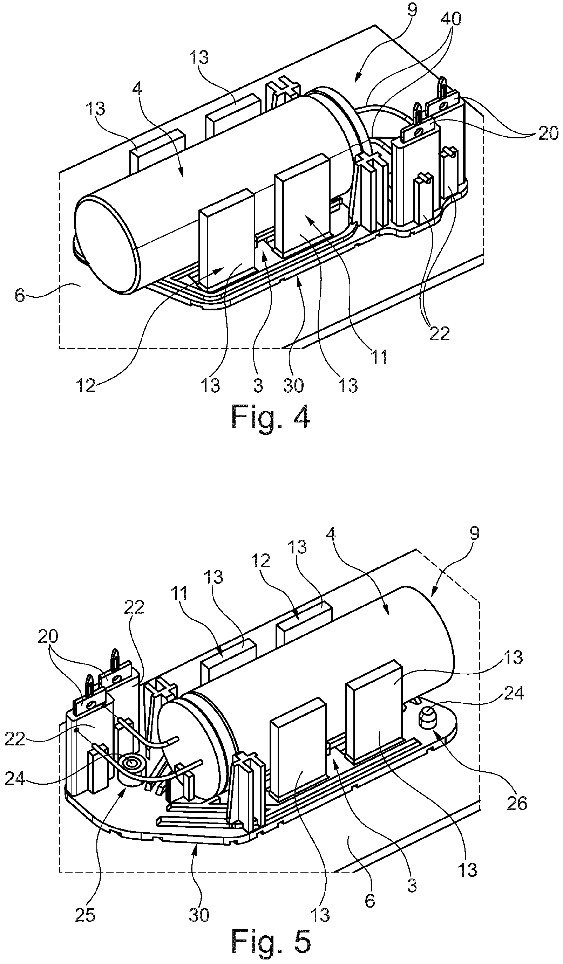

**Figure 4** and **Figure 5** are perspective views of an embodiment of the mounting structure **3** according to the invention mounted on an inner surface **6** of the cover **9.** The capacitor **4** is installed in the mounting structure **3.** A base **30** of the mounting structure **3** abuts to the inner surface **6** of the cover **9.** One possible embodiment of the mounting structure **3** shown here comprises two pairs **11** of two opposing holding elements **13,** which hold the capacitor **4** in position. Leads **40** of the installed capacitor **4** are guided to towers **22** of the mounting structure **3.** The leads **40** are each fixed an electrically contacted by an insulation displacement connector **20** inserted in each tower **22.**

As shown in **Figure 5****,** the inner surface **6** of cover **9** has at least two locating pins **24.** Each locating pin **24** is formed one the inner surface **6** of cover **9** is cooperating with the mounting structure **3.** One locating pin **24** reaches through an opening **26** in the base **30** of the mounting structure **3.** The other locating pin **24** cooperates with a centering feature **25** of the mounting structure **3.** The cooperation of the centering feature **25** and the opening **26** with the respective locating pins **24** enables a defined positioning of the mounting structure **3** on the inner surface **6** of the cover **9.**

It is clear to a person skilled in the art that the number of locating pins **24** and the number of pairs **11** of holding elements **13** are not to be understood as limiting the invention. For description purposes only, two pairs **11**of holding elements **13** and two locating pins **24** are provided. It is possible to provide at least one pair **11** of holding elements **13** on the mounting structure **3** and at least two locating pins **24** on the inner surface **3** of the cover **9.**

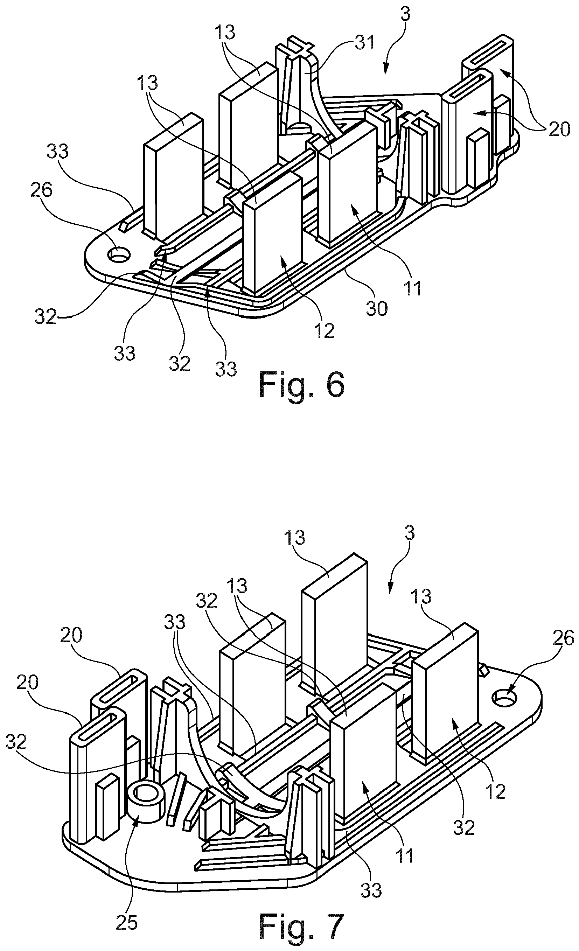

**Figure 6** and **Figure 7** show perspective views of a possible embodiment of the mounting structure **3** according to the invention from different angles. The mounting structure **3** has a base **30** carrying the two pairs **11** of opposing holding elements **13** and the towers **22** for receiving the insulation displacement connectors **20** (see Figure 5). The two pairs **11** of holding elements **13,** the towers **22,** an alignment support **31** for the capacitor **4,** and a plurality of support surfaces **32** for the capacitor **4** are integral parts of the mounting structure **3.** In addition, a plurality of reinforcement ribs **33** are formed on the base **30.** The opening **26** in the base **30** receives a locating pin **24** of the inner surface **6** of the cover **9.**

**Figure 7** shows that the base **30** also carries a centering feature **25** that receives a locating pin **24** (see Figure 5) of the inner surface **6** of the cover **9** when the mounting structure **3** is positioned on the inner surface **6** of the cover **9.**

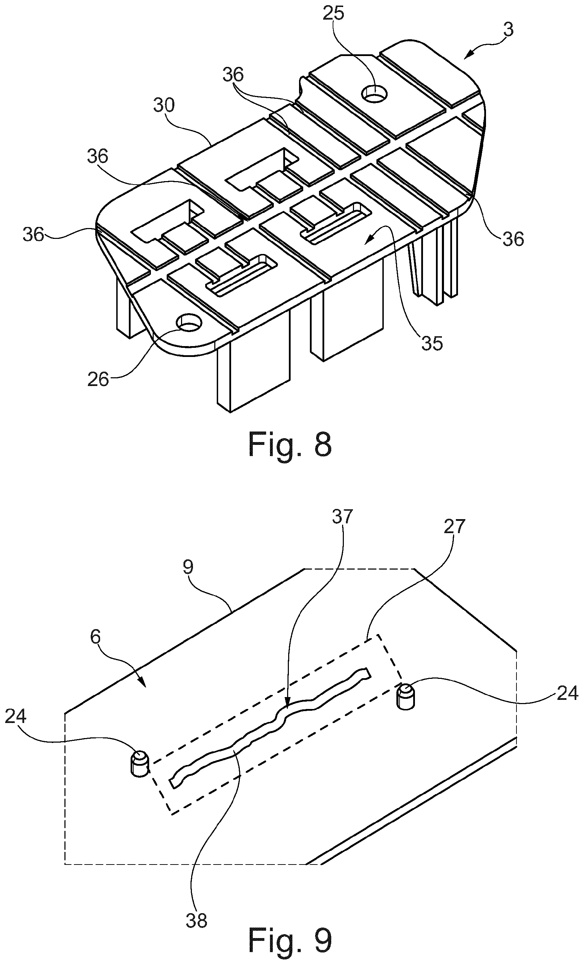

**Figure 8** is a perspective bottom view of a possible embodiment of the mounting structure **3** (cradle). A plurality of grooves **36** may be formed in a bottom surface **35** of the base **30** of the mounting structure **3.** The grooves **36** serve to squeeze a chemical substance **38** (see Figure 9) when the mounting structure **3** is positioned and pressed against the inner surface **6** of the cover **9.** The mounting structure **3** as described in Figs. 4 to 8 may be injection molded from an injection moldable material. It is evident for a person skilled in the art, that the bottom surface **35** of the base **30** of the mounting structure **3** can be flat and does not have grooves.

**Figure 9** is a schematic view of an initial method step for mounting the mounting structure **3** to a cover **9.** According to a possible embodiment, a strip **37** of a chemical substance **38** is applied to the inner surface **6** of cover **9** and approximately in the center of an area **27,** marked with a dashed line, between the locating pins **24.** It is clear for a person skilled in the art, that the chemical substance **38** needs not to be necessarily applied in the form of a strip **37.** The form of a strip **37** should not be regarded as a limitation of the invention.

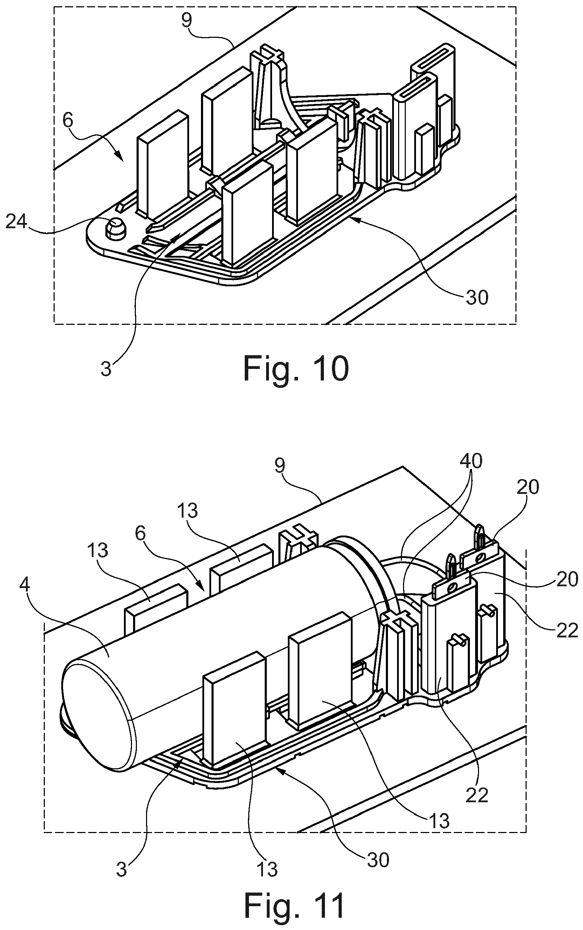

**Figure 10** is a schematic view of a subsequent method step for mounting the mounting structure **3** to the inner surface **6** of the cover **9.** Prior to placing the mounting structure **3** on the inner surface **6** of the cover **9,** the mounting structure **3** is aligned with the locating pins **24.** The mounting structure **3** is in the final mounting position when the locating pins **24** reach through the opening **26** and the centering feature **25** (see Figure 7) respectively. In the final mounting position, the base **30** of the mounting structure **3** cooperates with the chemical substance **38** (see Figure 9) on the inner surface **6** of the cover **9,** wherein the chemical substance **38** squeezes between the mounting structure **3** and the inner surface **6** of the cover **9.** The chemical substance **38** firmly attaches the mounting structure **3** to the inner surface **6** of the cover **9.**

**Figure 11** is a schematic view of a method step for mounting the capacitor **4** into the mounted mounting structure **3.** Once the capacitor **4** has been placed in the mounted mounting structure **3** and held in place firmly by the holding elements **13,** the leads **40** of capacitor **4** are inserted into the towers **20,** and the insulation displacement connector **20,** placed in each tower **22,** provides an electric contact with the respective leads **40.**

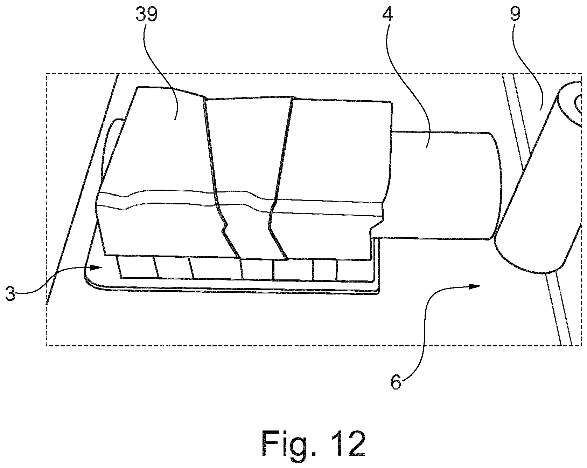

**Figure 12** is a schematic view of the capacitor **4** mounted and secured in the mounting structure **3.** One possible embodiment, as shown here, is the application of a shoring **39** to further secure the capacitor **4** in the mounting structure **3.**

It is believed that the present disclosure and many of its attendant advantages will be understood by the foregoing description, and it will be apparent that various changes may be made in the form, construction and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### LIST OF REFERENCE NUMERALS

- 1: Electronic control unit (ECU)
- 2: Housing
- 3: Mounting structure, cradle
- 4: Capacitor
- 5: Bottom
- 6: Inner surface
- 7: Circuit board
- 8: Electric connector
- 9: Cover
- 10: Electric circuitry
- 11: Pair
- 13: Holding element
- 14: contact pin
- 16: Vehicle
- 18: Vehicle battery
- 19: Electric line
- 20: Insulation displacement connector
- 22: Tower
- 24: Locating pin
- 25: Centering feature
- 26: Opening
- 27: Area
- 30: Base
- 31: Alignment support
- 32: Support surface
- 33: Reinforcement rib
- 35: Bottom surface
- 36: Groove
- 37: Strip
- 38: Chemical substance
- 39: Shoring
- 40: Lead

## Claims

1. A mounting structure (3) for a capacitor (4), comprising
a base (30),
at least one pair (11) of holding elements (13) and two towers (22) each for receiving an insulation displacement connector (20),
an alignment support (31), and
support surfaces (32),
**characterized by**
a plurality of reinforcement ribs (33) formed in an upper surface of the base (30) of the mounting structure (3); and
a centering feature (25) and an opening (26) formed in the base (30) of the mounting structure (3).

2. The mounting structure (3) according to claim 1, wherein a tow pairs (11) of holding elements (13) are provided.

3. The mounting structure (3) according to any one of the preceding claims, wherein the mounting structure (3) is injection moulded and the holding elements (13), the two towers (22), the alignment support (31), the support surfaces (32) and the reinforcement ribs (33) are integral parts of the injection moulded mounting structure (3).

4. The mounting structure (3) according to claim 3, wherein a plurality of grooves (36) are formed in a bottom surface (35) of the base (30) of the mounting structure (3).

5. The mounting structure (3) according to any one of the preceding claims, wherein the holding elements (13) are configured to hold the capacitor (4), and the towers (22) of the mounting structure (3) receive leads (40) of the capacitor (4).

6. An electronic control unit (1) with a mounting structure (3) according to any one of the preceding claims.

7. A method for mounting a mounting structure (3) to a housing (2) of an electronic control unit (1) comprising the steps of:
applying a chemical substance (38) with fixing properties in a center of an area (27) between locating pins (24) provided on an inner surface (6) of a cover (9) of the housing (2);
aligning at least one opening (26) and at least one centering feature (25) of a base (30) of the mounting structure (3) with respective locating pins (24) on the inner surface (6) of the cover (9) of the housing (2);
pressing the mounting structure (3) against the inner surface (6) of the cover (9) so that the locating pins (24) engage the at least one opening (26) and the at least one centering feature (25) respectively; and
squeezing the chemical substance (38) between the inner surface (6) of the cover (9) and a bottom surface (35) of the base (30) of the mounting structure (3).

8. The method according to claim 7, wherein the chemical substance (38) is applied

9. The method according to claim 8, wherein the chemical substance (38) is squeezed into grooves (36) in the bottom surface (35) of the base (30) of the mounting structure (3).

10. The method according to any one of claims 7 to 9, wherein a shoring (39) is applied to the capacitor (4) and the mounting structure (3).

11. An electronic control unit (1) with an energy reserve defined by a mounting structure (3) with a mounted capacitor (4) mounted with a method according to anyone of the claims 7 to 10.

12. A vehicle with an electronic control unit (1) as claimed in claim 11.
